# EUROPÄISCHE PATENTANMELDUNG

(11) **EP 2 980 527 A1**
(43) Veröffentlichungstag der Anmeldung: **03.02.2016**
(21) Anmeldenummer: 15176735.7
(22) Anmeldetag: 15.07.2015
(51) Int. Cl.: G01B 11/25, H01S 5/022, H01S 5/42

(54) **MESSEINRICHTUNG ZUM DREIDIMENSIONALEN OPTISCHEN VERMESSEN VON OBJEKTEN MIT EINEM TOPOMETRISCHEN SENSOR SOWIE VERWENDUNG EINES MULTI-LASERCHIP-BAUELEMENTES**

(30) Priorität: 01.08.2014 DE 102014110960
(71) Anmelder: GOM Gesellschaft für optische Meßtechnik mbH, 38106 Braunschweig (DE)
(72) Erfinder: GOMERCIC, Mladen, 38102 Braunschweig (DE); EVERS, Tim, 38104 Braunschweig (DE); JÖRCK, Michael, 38114 Braunschweig (DE); SCHMITLEIN, Alexander, 38116 Braunschweig (DE)
(74) Vertreter: Gerstein, Hans Joachim

(57) **Zusammenfassung**

Eine Messeinrichtung (1) zum dreidimensionalen optischen Vermessen von Objekten (2) mit einem topometrischen Sensor (3), der mindestens eine Projektionseinheit (10) zur Projektion eines Musters auf ein Objekt (2) und mindestens eine Bildaufnahmeeinheit (7) zur Aufnahme des vom Objekt (2) rückgestreuten Musters umfasst, wird beschrieben. Die Projektionseinheit (10) hat eine Laserlichtquelle (9) und einen mit der Laserlichtstrahlung der Laserlichtquelle (9) beaufschlagbaren Mustergenerator (10). Die Laserlichtquelle (9) weist mindestens ein Multi-Laserchip-Bauelement (15) auf, welches mehrere Laserdiodenchips (17) in einem gemeinsamen Multi-Laserchip-Gehäuse (16) hat, wobei die Laserdiodenchips (17) auf einer Montagefläche (18) des Multi-Laserchip-Gehäuses (16) aufgebracht und über die Montagefläche (18) thermisch an das Multi-Laserchip-Gehäuse (17) angebunden sind.

## Beschreibung

Die Erfindung betrifft eine Messeinrichtung zum dreidimensionalen optischen Vermessen von Objekten mit einem topometrischen Sensor, der mindestens eine Projektionseinheit zur Projektion eines Musters auf ein Objekt und mindestens eine Bildaufnahmeeinheit zur Aufnahme des vom Objekt rückgestreuten Musters umfasst, wobei die Projektionseinheit eine Laserlichtquelle und einen mit der Laserlichtstrahlung der Laserlichtquelle beaufschlagbaren Mustergenerator hat.

Die Erfindung betrifft weiterhin eine Verwendung eines Multi-Laserchip-Bauelementes, das mehrere Laserdiodenchips in einem gemeinsamen Multi-Laserchip-Gehäuse hat.

Die dreidimensionale optische Erfassung von Objektoberflächen mittels optischer Triangulationssensoren nach dem Prinzip der Topometrie ist in der Messtechnik weit verbreitet. Das Verfahren basiert auf der Projektion von Mustern auf das zu vermessende Objekt. Das rückgestreute Muster wird von einer oder mehreren Bildaufnahmeeinheiten aufgenommen und anschließend durch eine Bildauswerteeinheit ausgewertet.

Die durch die Projektionseinheit projizierten Muster können vielfältig ausgestaltet sein. Typische projizierte Muster sind stochastische aber auch deterministische Muster (z.B. Punkt- und Streifenmuster). Insbesondere Streifenmuster haben sich zum Beispiel aufgrund der prinzipiell einfachen Auswertung als gängiges Muster im Rahmen der optischen 3D-Messung etabliert.

Auf dem zu vermessenden Objekt entsteht durch das projizierte Muster eine künstliche, temporäre Textur. Diese wird durch mindestens eine Bildaufnahmeeinheit aufgenommen. Anhand der künstlich erzeugten, im Allgemeinen a priori bekannten Textur können beleuchtete 3D-Punkte auf dem zu vermessenden Objekt eindeutig sowohl in der Projektionseinheit als auch der einen oder mehreren Bildaufnahmeeinheiten identifiziert werden.

Im Anschluss an die Messung können die 3D-Koordinaten durch ein Triangulationsverfahren bestimmt werden. Die Voraussetzung ist, dass der gleiche Objektpunkt in mindestens zwei räumlich verschiedenen Aufnahmepositionen gemessen worden ist. Die Projektionseinheit kann dabei als inverse Kamera fungieren, so dass zur Bestimmung der 3D-Koordinaten die Messung mit einer Kamera ausreicht. Viele topometrische Systeme nutzen aber mehrere Kameras zur Erfassung der projizierten Textur. Die Projektionseinheit kann dann vorteilhaft nur noch als Texturgeber fungieren und wird nicht bei der 3D-Punkt-Berechnung berücksichtigt. Dadurch steigt im Allgemeinen die Genauigkeit der berechneten 3D-Punkte, da die mechanische und thermische Stabilität von Kameras deutlich einfacher zu realisieren ist.

Die Projektionseinheit umfasst mehrere wichtige Komponenten, um Muster auf das zu vermessende Objekt projizieren zu können. Diese sind insbesondere die Beleuchtungseinheit und der Mustergenerator. Die Projektionseinheit enthält ferner eine Projektionsoptik, die das Muster entsprechend der Ausgestaltung der Projektionsoptik auf das zu vermessende Objekt projiziert.

Die Beleuchtungseinheit stellt elektromagnetische Strahlung bereit. Je nach Ausführung der Beleuchtungseinheit wird elektromagnetische Strahlung mit charakterisierenden Eigenschaften erzeugt. Diese sind insbesondere der Wellenlängenbereich in dem die Lichtquelle Strahlung emittiert sowie die Leistung.

Der Mustergenerator beaufschlagt die durch die Beleuchtungseinheit bereitgestellte Strahlung mit einem Muster, so dass je nach Ausführungsform mindestens eine stochastische und/oder definierte deterministische Textur mit Hilfe der Projektionsoptik auf das zu vermessende Objekt projiziert werden kann.

Topometrische Sensoren arbeiten zu großer Mehrheit im Bereich des sichtbaren Lichtes. Dabei gibt es sowohl Systeme, die das gesamte Spektrum des sichtbaren Lichtes nutzen (Weißlicht), aber auch einzelne schmalbandige Bereiche (z.B. Rot-, Grün- oder Blaulicht). Vorbekannt sind auch Systeme, die im nahen Infrarot oder im Ultraviolett-Bereich arbeiten.

Die Verwendung eines breitbandigen Bereichs z.B. des gesamten sichtbaren Spektrums birgt einige Nachteile. So werden die Lichtanteile bei einem Übergang von einem Medium in ein anderes in Abhängigkeit von ihrer Wellenlänge unterschiedlich gebrochen. Dies führt zu einer Aufspreizung des originären Signals in seine einzelnen spektralen Bestandteile. Entsprechende Medienübergänge, z.B. Luft zu Glas, treten sowohl bei der Projektionsoptik des Projektors als auch bei der Abbildungsoptik der Bildaufnahmeeinheit auf. Der daraus resultieren Projektions- beziehungsweise Abbildungsfehler wird auch als chromatische Abberation bezeichnet. Zwar können durch entsprechendes Linsendesign solche Abbildungsfehler in Teilen verringert werden. Allerdings führt dies in der Regel aber auch zu höheren Kosten. Zudem verbleiben trotz Optimierung systematische Restabbildungsfehler insbesondere bei kurzbrennweitigen Optiken.

Ein weiterer Nachteil bei der Verwendung von breitbandiger Strahlung zur Musterprojektion ist der Einfluss von Fremdlichtquellen. Je nach Musterprojektionsart und Auswertemethodik führt Fremdlicht zur Verschlechterung des Signal-Rausch-Verhältnisses bis hin zur systematischen Verfälschung der Musterauswertung. So reduziert die von einer Fremdlichtquelle empfangene Strahlung, die im sensitiven Bereich der Bildaufnahmeeinheiten zeitlich konstant Strahlung emittiert, deren Nutzdynamikbereich. Für die eigentliche Signaldetektion und Signalauswertung verbleiben somit weniger Unterscheidungsstufen (Grauwerte). Beim gängigen Phasenschiebeverfahren, bei dem mindestens drei zueinander versetzte Streifenbilder projiziert werden, führt das zu einer kleineren maximal möglichen Modulation (Amplitude) des empfangenen Streifensignals, wodurch die Phasenauswertung und die nachfolgend daraus abgeleiteten 3D-Punkte stärker verrauscht sind. Wenn die Fremdlichtquelle zeitlich variabel Strahlung aussendet, die von den beteiligten Bildaufnahmeeinheiten empfangen wird, dann führt dies bei Phasenschiebeverfahren zu einer systematisch falschen Phasenauswertung und nachfolgend zu systematisch falschen 3D-Punkten.

Um den Einfluss von chromatischer Abberation und Fremdlichquellen zu reduzieren, können zum Beispiel Bandpassfilter für die Empfangsoptik der Bildaufnahmeeinheiten eingesetzt werden. Diese lassen nur das Licht in einem bestimmten Wellenlängenbereich durch, während alle sonstigen Lichtanteile reflektiert bzw. absorbiert werden.

Durch diese Maßnahme wird aber die für die Messung nutzbare Leistung der Lichtquelle gegebenenfalls sehr stark limitiert, sofern weiterhin eine breitbandige Lichtquelle verwendet wird. Um einen möglichst großen Anteil der ausgesandten Leistung für die eigentliche Messung nutzen zu können und den Umgebungslichteinfluss möglichst gering zu halten, ist eine Strahlungsquelle notwendig, die originär schmalbandiges Licht mit einer hohen Leistung erzeugt. Zudem ermöglicht eine hohe Lichtleistung kurze Belichtungszeiten. Dadurch ist das topometrische System robust gegen Relativbewegungen zwischen topometrischem Sensor und zu vermessendem Objekt. Weiterhin können so auch Objekte mit für das Messverfahren ungünstigem Reflexionsverhalten (z.B. gerichtete Reflexion, dunkle Objekte) gemessen werden. Zudem kann je nach Ausführung des Sensors der Arbeitsabstand zum Messobjekt beziehungsweise das Messvolumen vergrößert werden.

Neben der Zielsetzung der Verwendung einer schmalbandigen Lichtquelle sind weitere Eigenschaften hilfreich, um die Lichtquelle innerhalb einer Projektionseinheit optimal verwenden zu können. So muss die Lichtquelle eine hinreichend hohe Leistung bereitstellen, um kurze Belichtungszeiten zu ermöglichen und den Einfluss von Relativbewegungen zu reduzieren. Wünschenswert sind beispielsweise Leistungen von größer gleich 7 Watt (radiometric flux), um im industriellen Umfeld eine hinreichend starke Ausleuchtung des zu vermessenden Objekts zu gewährleisten. Ferner soll die Lichtquelle relativ klein und kompakt sein, damit die Gesamtabmessungen der Projektionseinheit und nachfolgend des topometrischen Sensors nicht zu groß werden.

Vorbekannt sind diverse, verschiedenartige Lichtquellen, die in einer Projektionseinheit eingesetzt werden können. Diese sind zum Beispiel Halogenlampe, Kurzbogenlampe, Metalldampflampe und Leuchtdiode. Vorbekannt ist auch der Einsatz eines Lasers in einer Projektionseinheit. Es handelt sich hierbei um Licht, welches durch stimulierte Emission erzeugt wird. Aufgrund der Erzeugung zeichnet sich die Laserstrahlung durch mehrere charakteristische Eigenschaften aus, welches Licht der vorgenannten Quellen im Allgemeinen nicht aufweist. So erzeugt der Laser kohärente Strahlung, also Strahlung gleicher Phasenlage. Zudem bewegt sich die emittierte Strahlung innerhalb eines engen Frequenzbandes. Man spricht auch von monochromatischem bzw. schmalbandigen Licht. Die emittierte Hauptwellenlänge hängt dabei vom aktiven Medium ab (z.B. Helium-Neon-Laser: 632,8nm).

Eine Laserlichtquelle mit einer definierten Hauptwellenlänge ist aufgrund ihres schmalbandigen Spektrums prinzipiell sehr gut geeignet. Sie kann baulich verschiedenartig z.B. als Festkörper-Laser, chemisch gepumpter Laser, Laserdiode etc. ausgestaltet sein. Allerdings sind viele Ausführungsformen nicht geeignet, um als Laserlichtquelle in einem topometrischen Sensor eingesetzt zu werden. So muss die Laserlichtquelle möglichst kompakt sein, damit die Gesamtabmessungen des topometrischen Sensors ebenfalls möglichst klein bleiben. Ferner muss die Laserlichtquelle möglichst leicht sein, damit die Mobilität und die Einsatzmöglichkeiten des topometrischen Sensors (z.B. topometrische Messungen bei dem der topometrische Sensor durch den Nutzer gehalten wird) nicht zu stark eingeschränkt werden. Zudem sollen die monetären Kosten für die Laserquelle und weitere Komponenten zur Strahlkollimation im topometrischen Sensor sowie Kühlung und Energieversorgung möglichst gering sein, damit die Gesamtkosten zur Produktion des topometrischen Sensors nicht überproportional ansteigen.

So sind Festkörper-Laser und chemisch gepumpte Laser aufgrund ihres großen Volumens, ihrer großen Massen, der hohen Preise und ihrer hohen Anforderungen hinsichtlich der Kühlung nicht für den Einsatz in einem mobilen topometrischen Sensor geeignet. Dagegen erfüllt eine Laserdiode prinzipiell die gestellten Anforderungen, da sie leicht, kompakt und preislich sehr günstig ist. Allerdings haben aktuelle Laserdioden, die Licht im sichtbaren Spektrum emittieren, trotz umfangreicher Forschung und Entwicklung in den letzten Jahren häufig nur maximale Leistungen von bis zu 3 Watt (radiometric flux). Um eine entsprechend der Aufgabenstellung hinreichend leistungsstarke Lichtquelle verfügbar zu haben, ist angestrebt, mehrere Laserdioden vorzugsweise des gleichen Typs (und damit der gleichen Hauptwellenlänge) in einer gemeinsamen Lichtquelle zu vereinen.

Wenn mehrere Laserdioden zu einer gemeinsamen Lichtquelle kombiniert werden sollen, so ist es hinsichtlich ihres Einsatzzweckes innerhalb einer Projektionseinheit erwünscht, dass diese räumlich eng benachbart angeordnet sind. Dadurch erleichtert sich zum einen die Strahlführung beziehungsweise Bündelung des Laserlichtes im weiteren Strahlengang innerhalb der Projektionseinheit. Zum anderen ermöglicht es den Bau einer kompakten Projektionseinheit. Allerdings ergibt sich dann das Problem der großen Wärmeentwicklung als Nebenprodukt der Laserlichterzeugung. In Folge steigen die Temperaturen der beteiligten Laserdioden an. Sie erwärmen sich dabei bei entsprechend dichterem Abstand zueinander entsprechend stärker. Ein Temperaturanstieg resultiert aber in einer höheren Verlustleistung und somit einer geringeren Lichtleistung je Laserdiode. Um die Betriebstemperatur der beteiligten Laserdioden möglichst im optimalen Bereich zu halten, ist deswegen eine hinreichend gute Kühlung zu gewährleisten. Die Kühlung muss umso höher sein, je mehr Laserdioden verwendet werden und je dichter sie zueinander angeordnet sind.

Mit wachsender Anzahl der in einer solchen Laserdiodenvorrichtung implementierten Laserdioden sinkt jeweils die optische Ausgangsleistung je Laserdiode, da sich die Laserdioden gegenseitig so stark erwärmen, dass die elektrooptische Effizienz überproportional abnimmt.

DE 10 2012 103 257 A1 schlägt zur Behebung des Nachteils herkömmlicher Laserdiodenvorrichtungen, zum Beispiel in einem sogenannten TO-Gehäuse (TO = Transistor Outline), die eine relativ schlechte thermische Anbindung der Laserdioden an das Gehäuse und damit die Umgebung aufweisen, eine Laserdiodenvorrichtung mit einem Gehäuse und mehreren auf einer Montagefläche in einer Kavität des Gehäuses montierten Laserdiodenchips vor. Zwischen Montagefläche und Laserdiodenchip ist jeweils ein Wärmeleitelement angeordnet.

Aufgabe der vorliegenden Erfindung ist es, eine verbesserte Messeinrichtung zum dreidimensionalen Vermessen von Objekten mit einem topometrischen Sensor zu schaffen, die eine hinreichend hohe Lichtleistung bei gleichzeitig geringer baulicher Größe aufweist.

Die Aufgabe wird durch eine Messeinrichtung gemäß Anspruch 1 und die Verwendung des Anspruchs 7 gelöst.

Für eine gattungsgemäße Messeinrichtung wird vorgeschlagen, eine Laserlichtquelle zu nutzen, die mindestens ein Multi-Laserchip-Bauelement aufweist, welches mehrere Laserdiodenchips in einem gemeinsamen Multi-Laserchip-Gehäuse hat, wobei die Laserdiodenchips auf einer Montagefläche des Multi-Laserchip-Gehäuses aufgebracht und über die Montagefläche thermisch an das Multi-Laserchip-Gehäuse angebunden sind.

Das in der o.g. DE 10 2012 103 257 A1 theoretisch beschriebene Multi-Laserchip-Bauelement, das für den Einsatz in Overheadprojektoren angeboten wird, hat sich als geeignet und besonders vorteilhaft für die Verwendung in einem topometrischen Sensor einer Messeinrichtung zur dreidimensionalen optischen Vermessung mittels Musterprojektion erwiesen. Es wurde erkannt, dass diese neue Bauform für eine Laserlichtquelle im Hinblick auf die benötigte Lichtleistung und ein möglichst schmales Lichtspektrum besonders geeignet ist, um mit einem Mustergenerator eines topometrischen Sensors Muster mit ausreichender Lichtstärke und Präzision auf ein Objekt zu projizieren und dabei eine hinreichende Wärmeabfuhr sicherzustellen. Das sogenannte Multi-Laserchip-Bauelement, das auch als "Multi-Die Laser Package" bezeichnet wird, weist eine Vielzahl von Laserdioden auf engem Raum auf, wobei die große thermische Energie, welche im Rahmen des Betriebs der Laserdioden anfällt, durch eine neuartige Anordnung und Ausgestaltung der Bauelemente insbesondere der Laserdioden und deren thermischer Anbindung an das Gehäuse, mit relativ kurzen Wegen aus dem unmittelbaren Umgebungsbereich der Laserdioden abgeleitet wird.

Eine besonders hohe optische Ausgangsleistung bei gleichzeitig sehr kompakter Bauweise wird durch eine Reihe von baulichen und konzeptionellen Maßnahmen erreicht. So sind die Laserdioden, d.h. die Laserdiodenchips, auf der Montagefläche des Gehäuses angeordnet und können deshalb sehr gut thermisch an das Gehäuse angebunden werden. Dadurch kann die während des Betriebs entstehende Abwärme effizient von den Laserdiodenchips weggeleitet werden.

Besonders vorteilhaft ist es, wenn das Multi-Laserchip-Bauelement mindestens ein Wärmeleitelement hat, das zwischen der Montagefläche des MultiLaserchip-Gehäuses und dem mindestens einen Laserdiodenchip angeordnet ist. Das Wärmeleitelement dient insbesondere dazu, den im Betrieb des mindestens einen Laserdiodenchips erzeugten Wärmestrom zwischen dem mindestens einen Laserdiodenchip und der Montagefläche aufzuweiten. Dadurch wird eine große Übergangsfläche von dem mindestens einen Laserdiodenchip zum Multi-Laserchip-Gehäuse erzielt.

Das Multi-Laserchip-Gehäuse kann dann vorzugsweise mit seiner Montagefläche mit einem geeigneten Kühlkörper verbunden werden, so dass Wärme von dem mindestens einen Laserdiodenchip effektiv abgeführt werden kann. Dadurch, dass die Abwärme durch das mindestens eine Wärmeleitelement auf eine besonders große Fläche der Montagefläche verteilt wird und von dort die Wärme über einen relativ kurzen Wärmeleitpfad an die Umgebung abgegeben wird, kann eine Vielzahl von Laserdiodenchips in baulich engem Abstand innerhalb eines Multi-Laserchip-Gehäuses angeordnet werden, ohne das die optische Leistung der einzelnen Laserdiodenchips durch gegenseitiges Erwärmen reduziert wird.

Die Anzahl der verwendeten Laserdiodenchips kann so variiert werden, dass eine hinreichend starke optische Leistung der Laserdiodenvorrichtung erzielt wird. Bei einer entsprechend großen Laserdiodenchipanzahl empfiehlt es sich, ein entsprechend größeres Multi-Laserchip-Gehäuse zu verwenden, bei dem die Abstände von benachbarten Laserdiodenchips im Vergleich zu einer Ausführungsform mit weniger Laserdiodenchips praktisch gleich bleibt.

Weiterhin kann es vorteilhaft sein, das jeder Laserdiodenchip auf einem eigenen Wärmeleitelement befestigt ist. Dies ermöglicht unter anderem eine einfachere Montage, da der jeweilige Laserdiodenchip in einem ersten Schritt auf dem zugehörigen eigenen Wärmeleitelement befestigt werden kann und nachfolgend ein oder mehrere Verbunde aus Laserdiodenchip und Wärmeleitelement zusammen auf der Montagefläche des Multi-Laserchip-Gehäuses befestigt werden.

Ferner kann es vorteilhaft sein, dass das Multi-Laserchip-Gehäuse als sogenanntes Butterfly-Gehäuse ausgestaltet ist. In Abweichung zu einem herkömmlichen Butterfly-Gehäuse umfasst das Gehäuse ein Abdeckelement, welches die Gehäusekavität an der Gehäuseoberseite (also auf der entgegengesetzten Seite bezüglich der Montageseite) abschließt und das Abdeckelement ein Fensterelement umfasst, durch den die durch den mindestens einen Laserdiodenchip erzeugte optische Strahlung nach außen abgestrahlt werden kann. Das Fensterelement ist dabei zumindest teilweise vorzugsweise vollständig transparent für die von dem mindestens einen Laserdiodenchip emittierte Strahlung. Weiterhin kann das Abdeckelement optional ein Streuelement und oder mindestens ein Linsenelement enthalten, welches die Lichtstrahlung des mindestens einen Laserdiodenchip diffus streuen und oder eine Strahlformung bewirken. Optional kann das Abdeckelement nicht nur einen Fensterbereich haben, sondern jeder einzelne Laserdiodenchip kann die durch ihn erzeugte Lichtstrahlung durch ein eigenes Fensterelement abstrahlen. Die Fensterelemente sind Bestandteil des Abdeckelements und können mannigfaltig ausgestaltet sein. So können die Fensterelemente als strahlformende Elemente z.B. als Streu- und oder Linsenelemente ausgebildet sein.

Die Laserdiodenvorrichtung hat vorzugsweise mindestens ein Umlenkelement, welches die optische Strahlung, die durch mindestens einen Laserdiodenchip bereitgestellt wird, in Richtung des Fensterelements umlenkt.

Die Laserdiodenchips können aber auch so angeordnet sein, dass das Licht direkt in Abstrahlrichtung, also senkrecht zur Montageplatte abgestrahlt wird. In diesem Fall ist kein Umlenkelement notwendig. Eine praktische Ausformung eines Multi-Laserchip-Bauelementes, bei dem die Laserdiodenchips senkrecht zur Montageplatte angeordnet sind und das Licht ohne Umlenkelement direkt senkrecht zur Montageplatte abgestrahlt wird ist das Laserchip-Bauelement mit der Typenbezeichnung "PLPM4 450" des Unternehmens OSRAM Opto Semiconductors GmbH.

Die Multi-Laserchip-Bauelemente ermöglichen die Verwendung von zwei oder mehr solcher Multi-Laserchip-Bauelementen nebeneinander in einer Projektionseinheit, um damit bei beherrschbarer Kühlproblematik die erzielbare optische Ausgangsleistung von topometrischen Sensoren weiter zu steigern.

Ein weiterer Vorteil der sogenannten "Multi-Die Laser Package"-Bauweise ist der sehr einfache Ein- und Ausbau der Laserdiodenvorrichtung in der Projektionseinheit. Zudem generiert die Installation und Justage einer solchen Laserlichtquelle deutlich weniger Aufwand als bei einer Vielzahl von herkömmlichen Laserdiodenvorrichtungen (z.B. in der TO-Bauweise).

Die Erfindung wird nachfolgend anhand von Ausführungsbeispielen mit den beigefügten Zeichnungen näher erläutert. Es zeigen:
- Fig. 1: - Skizze einer Messeinrichtung zum dreidimensionalen optischen Vermessen von Objekten mit einem Multi-Laserchip-Bauelement mit mehreren Laserdiodenchips;
- Fig. 2a: - Skizze eines Multi-Laserchip-Bauelementes mit 25 Laserchipdioden in einer Grundriss-Darstellung;
- Fig. 2b: - Skizze eines Multi-Laserchip-Bauelementes mit 25 Laserchipdioden in einer perspektivischen Schräg-Darstellung;

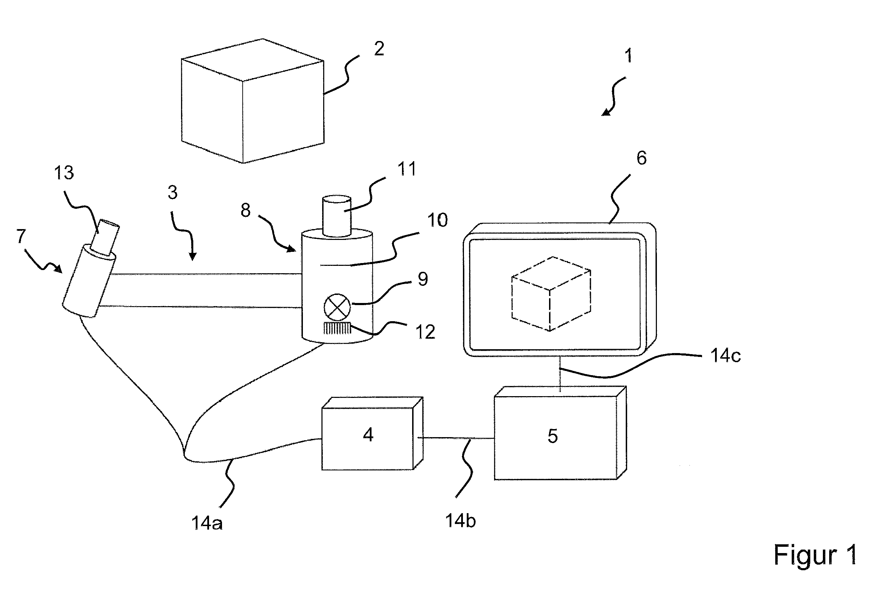

Figur 1 zeigt eine Messeinrichtung 1 zum dreidimensionalen optischen Vermessen von Objekten 2. Die Messeinrichtung 1 hat einen topometrischen Sensor 3, eine an sich bekannte Steuereinheit 4 zur Ansteuerung des topometrischen Sensors 3, eine an sich bekannte Auswerteeinheit 5 zur topometrischen Auswertung der von dem topometrischen Sensor 3 aufgenommenen Bilder des Objektes 2 sowie eine Anzeigeeinheit 6. Der topometrische Sensor 3 hat die originäre Aufgabe mindestens ein Muster auf das zu vermessende Objekt 2 zu projizieren und das vom Objekt 2 rückgestreute Signal des mindestens einen projizierten Musters mit mindestens einer Bildaufnahmeeinheit 7 des topometrischen Sensors 3 aufzunehmen. Die Projektion des mindestens einen Musters wird durch eine Projektionseinheit 8 ausgeführt.

Die Projektionseinheit 8 besteht im Wesentlichen aus einer Beleuchtungseinheit, die als Laserlichtquelle 9 ausgeführt ist, einem Mustergenerator 10 und einer Projektionsoptik 11. Die Projektionseinheit 8 ist so ausgestaltet, dass stochastische und oder deterministische Muster erzeugt und auf das zu messende Objekt 2 projiziert werden können. Die Laserlichtquelle 9 ist aus mindestens einem Multi-Laserchip-Bauelement (auch Multi-Die Laser Package genannt) gebildet. Ein solches Multi-Laserchip-Bauelement umfasst eine definierte Vielzahl an Laserdiodenchips, wie zum Beispiel eine Anzahl von 25 Laserdiodenchips. Aufgrund der Anordnung und Ausgestaltung der Laserdiodenchips und deren thermischer Anbindung an das Multi-Laserchip-Gehäuse kann die thermische Abwärme aus dem unmittelbaren Umgebungsbereich der Laserdioden abgeleitet werden. Die Laserlichtquelle 9 mit seinem mindestens einen Multi-Laserchip-Gehäuse ist vorteilhaft auf einem Kühlkörper 12 befestigt. Die von den Laserdiodenchips während des laufenden Betriebs erzeugte thermische Abwärme wird über mindestens ein Wärmeleitelement aufgeweitet und auf kurzem Wege an das Gehäuse der Laserlichtquelle 9 insbesondere die Gehäuseunterseite übertragen und dort über den Kühlkörper 12 an die Umwelt abgegeben. Dadurch fällt die optische Leistung der beteiligten Laserdiodenchips nicht deutlich unter deren Nennleistung zurück, da die Temperatur der Laserdiodenchips aufgrund der effektiven Kühlung nicht stark ansteigt.

Das Laserlicht der Laserlichtquelle 9 wird zu dem Mustergenerator 10 geleitet. Im vorliegenden Ausführungsbeispiel ist der Mustergenerator 10 als digitale Mikrospiegeleinheit (Digital Micromirror Device - DMD) ausgestaltet. In der Praxis hat sich der Einsatz einer digitalen Mikrospiegeleinheit als Mustergenerator 10 bewährt. Er besteht im Wesentlichen aus einem Flächenlichtmodulator, der aus matrixförmig angeordneten Mikrospiegelaktoren, das heißt verkippbar spiegelnden Flächen gebildet ist. Die Ausrichtung der Vielzahl von einzeln bewegbaren Spiegeln ist durch digitale Ansteuerung einzeln anpassbar und es sind je Spiegel je zwei Zustände der Ausrichtung möglich.

Der Mustergenerator 10 kann aber auch anders ausgestaltet sein. So können z.B. analoge Diaelemente (z.B. aus Glas) mit einem oder mehreren festen Mustern eingesetzt werden. Zudem kann das mindestens eine Diaelement bezüglich der Lichtquelle in Bewegung gebracht werden (z.B. Rotation und/oder Translation). Ferner könnten auch andere programmierbare Displays wie Liquid-Crystal-On-Silicon (LCOS) oder Liquid-Crystal-Display (LCD) eingesetzt werden.

Das durch den Mustergenerator 10 mit dem zu projizierenden Muster beaufschlagte Laserlicht wird durch die Projektionsoptik 11 auf das Objekt 2 projiziert. Die vom Objekt 2 reflektierten Lichtanteile werden über eine Empfangsoptik 13 von der Bildaufnahmeeinheit 7 in Form eines oder mehrerer 2D-Bilder aufgenommen.

Der topometrische Sensor 3 wird durch eine Steuerungseinheit 4 (Controller) gesteuert. Die Auswertung der aufgenommenen Bilddaten der Bildaufnahmeeinheit 7 sowie der projizierten Musterdaten erfolgt durch eine Bildauswerteeinheit 5. Die Darstellung der Ergebnisse wird durch eine Darstellungseinheit 6 realisiert. Die Datenübertragung zwischen den einzelnen Komponenten erfolgt durch eine geeignete Kabelverbindung 14a-14c.

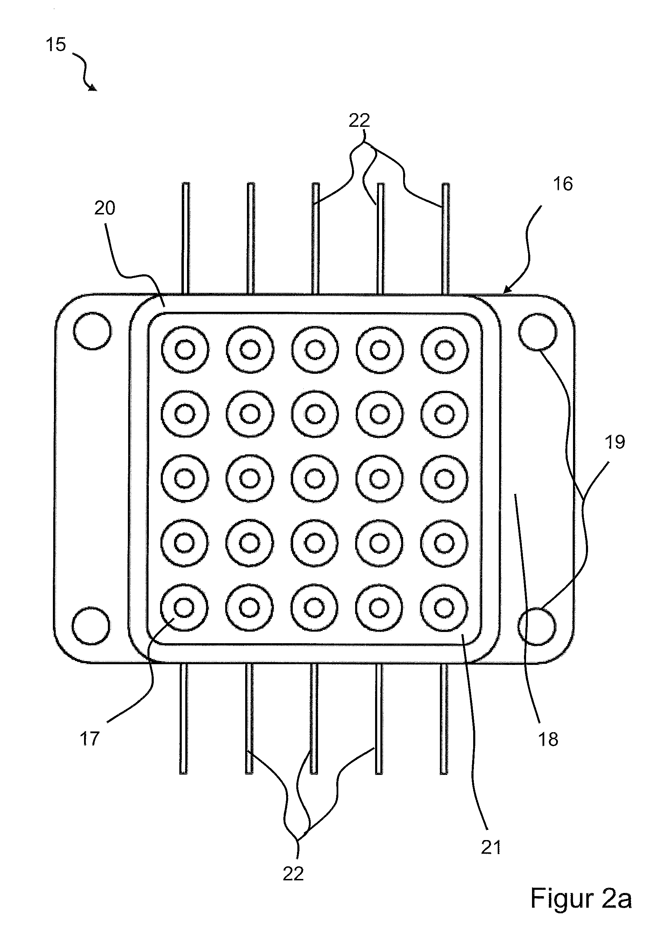

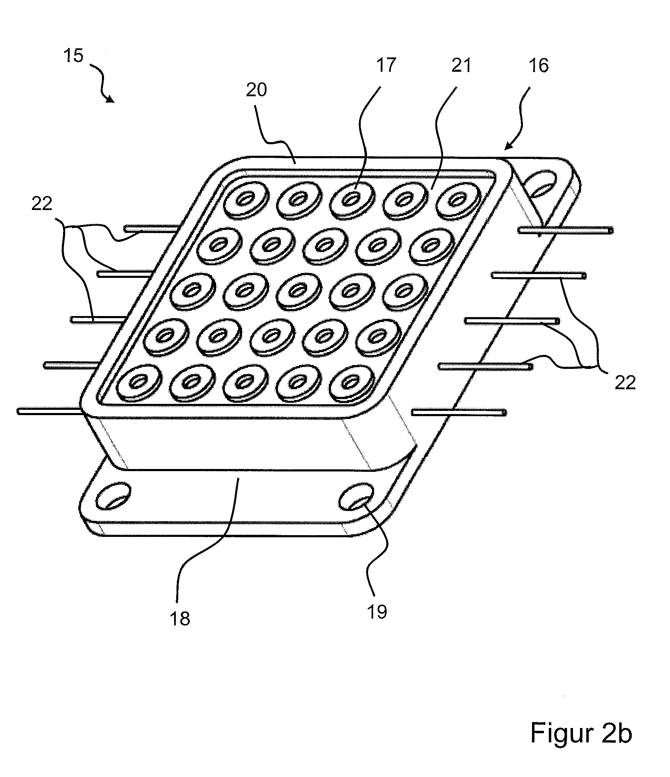

Figur 2a-b zeigt eine schematische Darstellung einer bevorzugten Ausführung der als Multi-Laserchip-Bauelement 15 ausgeführten Laserlichtquelle 9 in einer Grundrissdarstellung (Figur 2a) und einer perspektivischen Schrägdarstellung (Figur 2b).

Die Laserlichtquelle 9 hat in dem dargestellten Ausführungsbeispiel ein Multi-Laserchip-Bauelement 15 (auch Multi-Die Laser Package genannt) mit einem Multi-Laserchip-Gehäuse 16. Sie umfasst eine definierte Vielzahl an Laserdiodenchips 17, zum Beispiel eine Anzahl von 25 Laserdiodenchips 17. Aufgrund der Anordnung und Ausgestaltung der Bauelemente insbesondere der Laserdiodenchips 17 und deren thermischer Anbindung an das Multi-Laserchip-Gehäuse 16 kann die thermische Abwärme aus dem unmittelbaren Umgebungsbereich der Laserdiodenchips 17 abgeleitet werden. Das Multi-Laserchip-Gehäuse 16 der Laserlichtquelle 9 ist vorteilhaft auf einen Kühlkörper 12 befestigt. Die von den Laserdiodenchips 17 während des laufenden Betriebs erzeugte thermische Abwärme wird über mindestens ein Wärmeleitelement aufgeweitet, das zwischen den Laserdiodenchips 17 und einer Montagefläche 18 des Multi-Laserchip-Gehäuses 16 angeordnet ist, und auf kurzem Wege an das Multi-Laserchip-Gehäuse 16 der Laserlichtquelle 9, insbesondere auf die Gehäuseunterseite, übertragen und dort über den Kühlkörper 12 an die Umwelt abgegeben. Dadurch fällt die optische Leistung der beteiligten Laserdiodenchips 17 nicht deutlich unter deren Nennleistung zurück, da die Temperatur der Laserdiodenchips 17 aufgrund der effektiven Kühlung nicht stark ansteigt. Das Multi-Laserchip-Gehäuse 16 umfasst Montageabschnitte 19 mit denen die Laserlichtquelle 9 mechanisch mit dem Kühlkörper 12 verbunden werden kann.

Das Multi-Laserchip-Gehäuse 16 ist in Form eines Butterfly-Gehäuses ausgestaltet. Es hat einen von der Montagefläche 18 abragenden umlaufenden Kragen 20, der eine Kavität bildet, in der die Laserdiodenchips 17 eingebracht sind. Die Strahlaustrittsseite der Kavität ist mit einem Abdeckelement 21 verschlossen, das zumindest im Bereich des Strahlaustritts der einzelnen Laserdiodenchips 17 transparent (d.h. zumindest für die Haupt-Wellenlänge des emittierten Laserlichtes lichtdurchlässig) ist.

Die Steuerung der Laserdiodenchips 17 erfolgt über metallische Pins 22 oder Anschlussflächen o.ä., die z.B. auf jeweils zwei gegenüberliegenden Seiten des Gehäuses angeordnet sind.

## Patentansprüche

1. Messeinrichtung (1) zum dreidimensionalen optischen Vermessen von Objekten (2) mit einem topometrischen Sensor (3), der mindestens eine Projektionseinheit (10) zur Projektion eines Musters auf ein Objekt (2) und mindestens eine Bildaufnahmeeinheit (7) zur Aufnahme des vom Objekt (2) rückgestreuten Musters umfasst, wobei die Projektionseinheit (10) eine Laserlichtquelle (9) und einen mit der Laserlichtstrahlung der Laserlichtquelle (9) beaufschlagbaren Mustergenerator (10) hat, **dadurch gekennzeichnet, dass** die Laserlichtquelle (9) mindestens ein Multi-Laserchip-Bauelement (15) aufweist, welches mehrere Laserdiodenchips (17) in einem gemeinsamen Multi-Laserchip-Gehäuse (16) hat, wobei die Laserdiodenchips (17) auf einer Montagefläche (18) des Multi-Laserchip-Gehäuses (16) aufgebracht und über die Montagefläche (18) thermisch an das Multi-Laserchip-Gehäuse (17) angebunden sind.

2. Messeinrichtung (1) nach Anspruch 1, **dadurch gekennzeichnet, dass** das Multi-Laserchip-Bauelement (15) mindestens ein Wärmeleitelement umfasst, welches zwischen der Montagefläche (14) des Multi-Laserchip-Gehäuses (16) und den Laserdiodenchips (17) angeordnet ist.

3. Messeinrichtung (1) nach einem der vorhergehenden Ansprüche, **dadurch gekennzeichnet, dass** die Laserlichtquelle (9) zwei oder mehr nebeneinander angeordnete und miteinander gekoppelte Multi-Laserchip-Bauelemente (15) hat.

4. Messeinrichtung (1) nach einem der vorhergehenden Ansprüche, **dadurch gekennzeichnet, dass** die Messeinrichtung (1) eine Bildauswerteeinheit (5) hat, die zur topometrischen Auswertung der mit der mindestens einen Bildaufnahmeeinheit (7) aufgenommenen Bilder mit den vom Objekt (2) rückgestreuten Mustern für das optische Vermessen des Objektes (2) eingerichtet ist.

5. Messeinrichtung (1) nach einem der vorhergehenden Ansprüche, **dadurch gekennzeichnet, dass** der Mustergenerator (10) als digitale Mikrospiegeleinheit ausgestaltet ist.

6. Messeinrichtung (1) nach einem der vorhergehenden Ansprüche, **dadurch gekennzeichnet, dass** das mindestens eine Multi-Laserchip-Gehäuse (15) mit seiner Montagefläche (18) mit einem außerhalb des Multi-Laserchip-Gehäuses (15) angeordneten Kühlkörper (12) verbunden ist.

7. Verwendung eines Multi-Laserchip-Bauelementes (15), das mehrere Laserdiodenchips (17) in einem gemeinsamen Multi-Laserchip-Gehäuse (16) hat, wobei die Laserdiodenchips (17) auf einer Montagefläche (18) des Multi-Laserchip-Gehäuses (16) aufgebracht und über die Montagefläche (18) thermisch an das Multi-Laserchip-Gehäuse (16) angebunden sind, als Laserlichtquelle (9) einer Projektionseinheit (8) eines topometrischen Sensors (3) zum dreidimensionalen optischen Vermessen von Objekten durch Projektion mindestens eines Musters auf ein Objekt (2) mit Hilfe der Projektionseinheit (8) und Aufnehmen des Objektes (2) mitsamt dem mindestens einen von dem Objekt (2) rückgestreuten Muster.

8. Verwendung nach Anspruch 7 , **dadurch gekennzeichnet, dass** das Multi-Laserchip-Bauelement (15) mindestens ein Wärmeleitelement umfasst, welches zwischen der Montagefläche (18) des Multi-Laserchip-Gehäuses (16) und den Laserdiodenchips (17) angeordnet ist.

9. Verwendung nach Anspruch 7 oder 8, **dadurch gekennzeichnet, dass** die Laserlichtquelle (9) zwei oder mehr nebeneinander angeordnete und miteinander gekoppelte Multi-Laserchip-Bauelemente (15) hat.

10. Verwendung nach einem der Ansprüche 7 bis 9, **gekennzeichnet durch** Erzeugen der Muster mit mindestens einer digitalen Mikrospiegeleinheit als Mustergenerator (10).
